# EUROPEAN PATENT SPECIFICATION

(11) **EP 0 488 366 B1**
(45) Date of publication and mention of the grant of the patent: **14.05.1997**
(21) Application number: 91120509.4
(22) Date of filing: 29.11.1991
(51) Int. Cl.: G11C 16/06, G11C 5/14

(54) **Wrist watch**
Armbanduhr
Montre-bracelet

(30) Priority: 30.11.1990 JP 334528/90; 13.12.1990 JP 402066/90
(43) Date of publication of application: 03.06.1992
(73) Proprietor: CASIO COMPUTER COMPANY LIMITED, Shinjuku-ku Tokyo 160 (JP)
(72) Inventor: Inomata, Shinichi, c/o Pat. Dept. Dev.Div., Hamura, Hamura-shi, Tokyo 190-11 (JP); Nakazawa, Eiji, c/o Pat. Dept. Dev.Div., Hamura, Hamura-shi, Tokyo 190-11 (JP); Miyata, Hisashi, c/o Pat. Dept. Dev.Div., Hamura, Hamura-shi, Tokyo 190-11 (JP); Hagihira, Toru, c/o Pat. Dept. Dev.Div., Hamura, Hamura-shi, Tokyo 190-11 (JP)
(74) Representative: Grünecker, Kinkeldey, Stockmair & Schwanhäusser Anwaltssozietät

(56) References cited:
- EP-A- 0 213 588
- EP-A- 0 340 981
- US-A- 4 564 922
- US-A- 4 712 923
- PATENT ABSTRACTS OF JAPAN vol. 8, no. 10 (P-248)(1447) 18 January 1984 & JP-A-58 169 395
- PATENT ABSTRACTS OF JAPAN vol. 14, no. 382 17 August 1990 & JP-A- 21 40 151

## Description

The present invention relates to a wrist watch according to the preamble part of claim 1 including a volatile memory, in which stored data is lost when the power supply voltage is lowered or cut off. Such type of wrist watch is known for example from EP-A-213 588.

A volatile memory such as a RAM is used as a memory for storing the data. In a volatile memory, stored data is lost when the power supply voltage is lowered or cut off. For this reason, in some devices, a nonvolatile memory such as an EEPROM is used in addition to a RAM as disclosed for example in US-A-4 564 922.

A nonvolatile memory such as an EEPROM, however, has various drawbacks, e.g., a small memory capacity, a limited data write count, and a high voltage for a data write operation leading to large current consumption.

More specifically, in an apparatus in which data are frequently written in a memory, if an EEPROM is used as the memory, and the data write count limit is exceeded, the apparatus itself cannot be used unless the EEPROM is replaced with a new one. In addition, if a battery or the like is used as a power supply, since a data write operation must be performed with a high voltage, the service life of the battery is shortened.

From JP-A-85 16 9395 it is known to add and enter the number of times of rewriting to a ROM whenever a data is rewritten and to monitor whether the number reaches a rewriting limit. In this case an alarm is generated in order to inform the user about this operation state.

The object of the present invention is to provide a wrist watch which has a low power consumption is capable of reliable preserving data even if the power supply voltage is lowered or cut off.

This object is solved by wrist watch having the features of claim 1.

Preferred embodiments are subject to various dependent claims.

This invention can be more fully understood from the following detailed description when taken in conjunction with the accompanying drawings, in which:
Fig. 1 is a perspective view of an electronic wristwatch according to the present invention,
Fig. 2 is a perspective view showing a display portion of the electronic wristwatch,
Fig. 3 is a block diagram showing the circuit arrangement of the electronic wristwatch,
Fig. 4 is a view showing the memory architecture of a RAM 6 in Fig. 3,
Fig. 5 is a view showing the memory architecture of EEPROM 7 in Fig. 3,
Figs. 6 to 10 are flow charts respectively showing sequences of operations, and
Fig. 11 is a block diagram showing changes in display mode, based on switching operations;
Fig. 12 is a view showing changes in display during a data setting operation;
Fig. 13 is a view showing changes in display during a data sequential search;
Fig. 14 is a view showing a display state during a data transfer operation;
Figs. 15 and 16 are flow charts showing operations in the second embodiment of the present invention; and
Figs. 17 to 21 show the third embodiment of the present invention, in which:

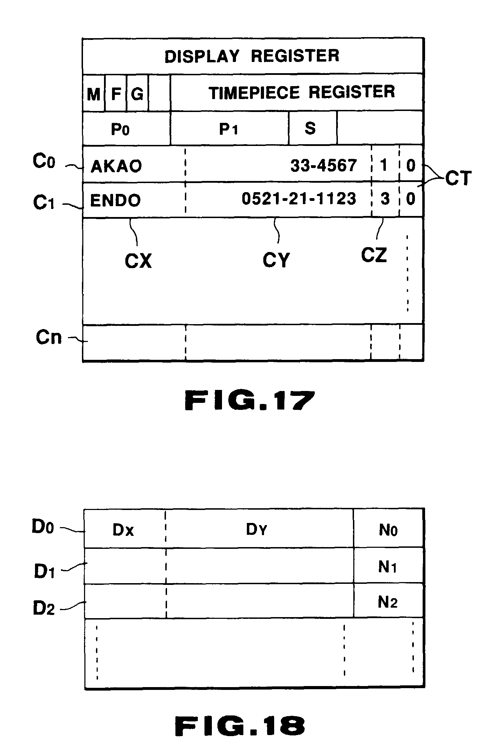

Fig. 17 is a view showing the memory architecture of a RAM,
Fig. 18 is a view showing the memory architecture of an EEPROM,

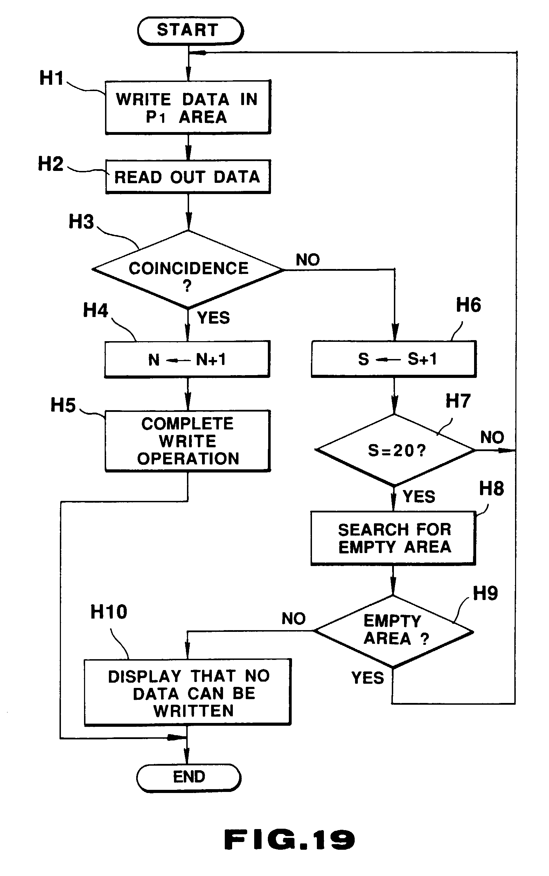

Fig. 19 is a flow chart showing a sequence of operations, and

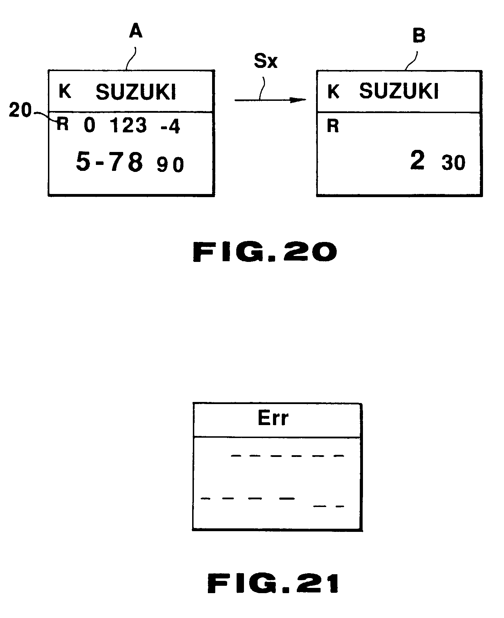

Figs. 20 and 21 are views respectively showing display states.

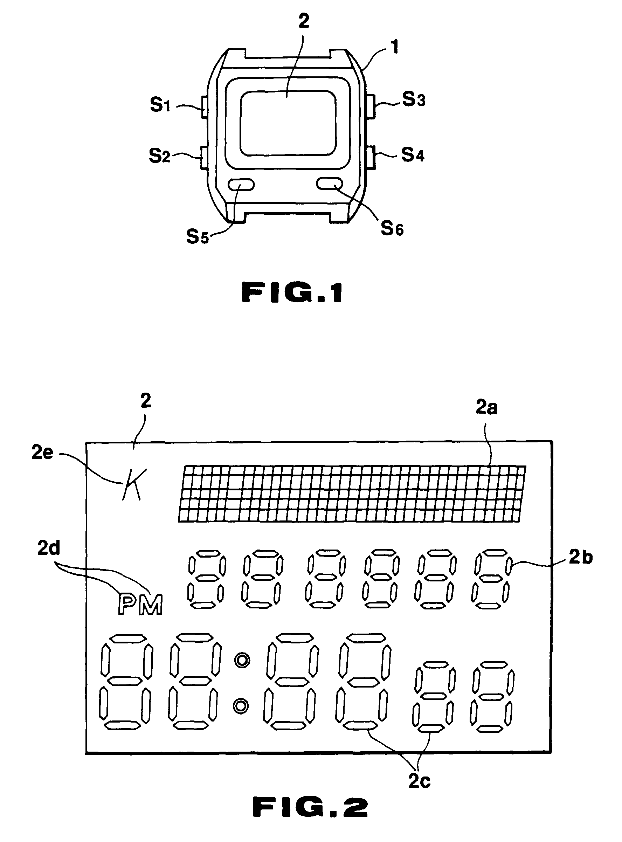

An embodiment of the present invention will be described below with reference to Figs. 1 to 14.

Fig. 1 is a perspective view of an electronic wristwatch. An LCD (liquid crystal display) 2 and an S₁ key to an S₆ key constituted by push-button switches are arranged on an electronic wristwatch main body 1. The S₁ key serves to switch a current time display mode and a data display mode, which will be described later. The S₂ key serves to switch a data display state in which stored data is displayed, and a set data display state in which data is input, and is also used to perform data editing, as will be described later. The S₃ key serves to perform a sequential search operation in which stored data are sequentially displayed on the LCD 2. The S₄ key serves to perform data transfer processing and is also used to select a character when data correction is performed. The S₅ key serves to select a digit position when data correction is performed. The S₆ key is used to perform other processing.

Fig. 2 shows the arrangement of the LCD 2. The LCD 2 comprises a dot matrix display portion 2a for displaying characters, numeric segment display portions 2b and 2c for displaying numerals, a PM symbol display portion 2d, and a "keep" mark display portion (K display portion) 2e. The dot matrix display portion 2a displays name data included in name/telephone-number data. The numeric segment display portions 2b and 2c display time data or telephone number data included in name/telephone-number data. The "keep" mark display portion (K) 2e indicates that name/telephone-number data displayed on the dot matrix display portion 2a and the numeric segment display portions 2b and 2c is kept in an EEPROM 7 (to be described later).

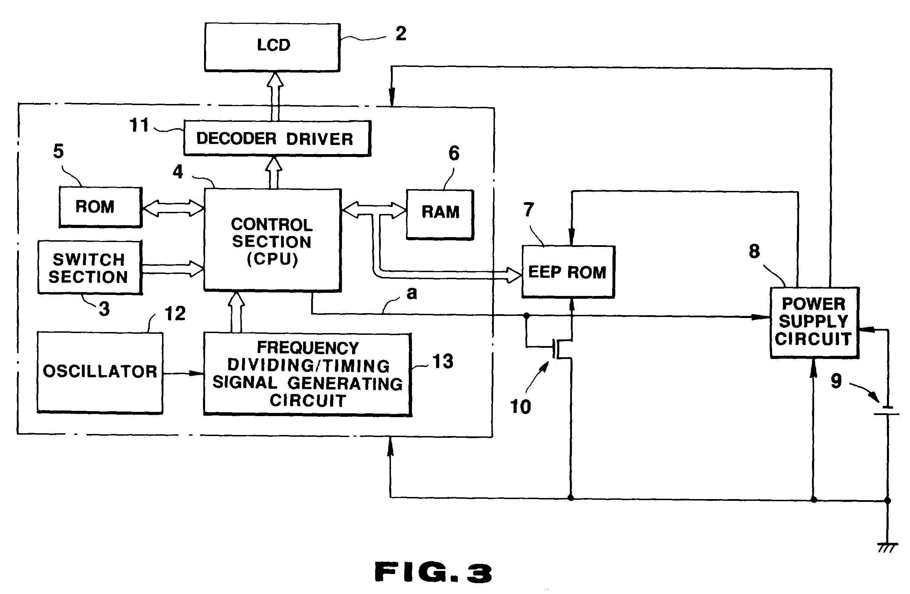

Fig. 3 is a block diagram showing the circuit arrangement of the electronic wristwatch. Referring to Fig. 3, a switch section 3 includes the S₁ key to the S₆ key shown in Fig. 1, and serves to output a key input signal corresponding to a key input to a control section (CPU) 4. The control section 4 is a central processing section for performing various types of processing in accordance with microprograms stored in a ROM 5 in advance. A RAM 6 is a volatile memory for storing various data such as name/telephone-number data and current time data. The EEPROM (electrically erasable and programmable read only memory) 7 as a nonvolatile memory capable of rewrite operation serves to store arbitrarily selected name/telephone-number data. A power supply circuit 8 applies a driving voltage (1.5V) to the respective components in accordance with a voltage (3V) applied from a lithium battery 9, and also supplies a predetermined voltage (2V) to the EEPROM 7 in response to a signal a output from the control section 4. A MOS transistor 10 is a gate element for controlling the supply of power to the EEPROM 7. In response to the signal a output from the control section 4, the MOS transistor 10 is turned on to connect the EEPROM 7 to the ground voltage (GND).

A decoder driver 11 outputs a display driving signal to the LCD 2 in accordance with display data output from the control section 4. An oscillator 12 incorporates a quartz oscillator and outputs, e.g., a 32-kHz (32768) clock pulse to a frequency dividing/timing signal generating circuit 13. The frequency dividing/timing signal generating circuit 13 frequency-divides the clock pulse supplied from the oscillator 12 to generate various types of timing signals such as a timepiece signal. The circuit 13 then outputs the timing signals to the control section 4.

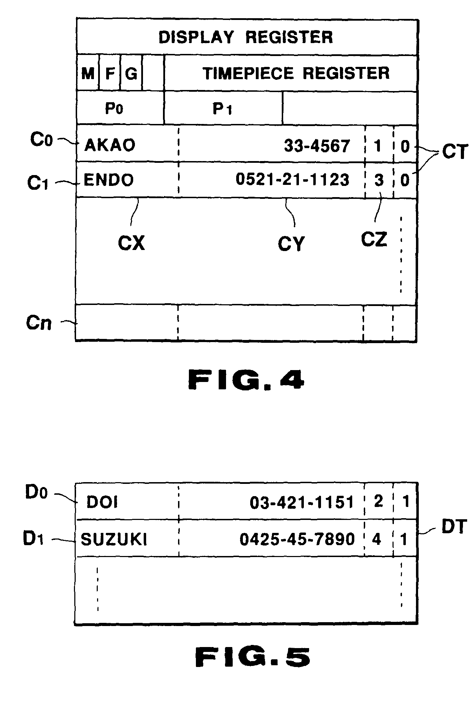

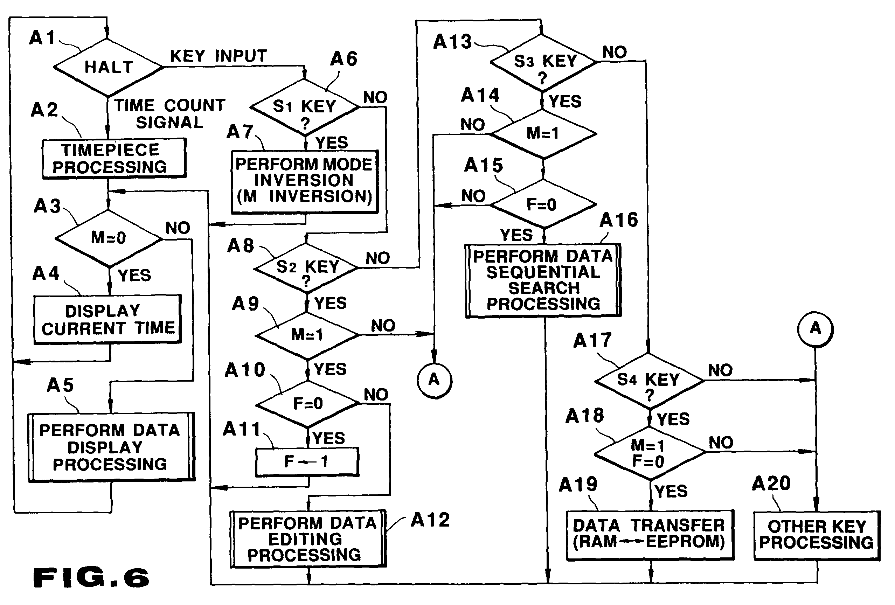

Fig. 4 shows the memory architecture of the RAM 6. As shown in Fig. 4, the RAM 6 includes various types of registers and TEL data memories C₀ to Cₙ for storing name/telephone-number data. A display register is a register for storing data to be displayed on the LCD 2. A mode register M is a register for storing a mode flag. When M = 0 (the value of the register M is "0"), the current time display mode is set. When M = 1, the data display mode is set. A flag register F stores a flag indicating whether data correction is being performed. A flag register G stores a selection flag indicating whether the RAM 6 or the EEPROM 7 is selected in a data read/write operation. When G = 0, the RAM 6 is selected. When G = 1, the EEPROM 7 is selected. A timepiece register serves to store the current time (date and time) counted by the control section 4. A register P₀ is a pointer for designating an address of each of the TEL data memories C₀ to Cₙ. A register P₁ is a pointer for designating an address of each of TEL data memories D₀, D₁,... in the EEPROM 7 shown in Fig. 5. In each of the TEL data memories C₀ to Cₙ, alphabetic name data is stored in an area CX, telephone number data is stored in an area CY, order data indicating the order of read operations in a sequential search is stored in an area CZ, and a "keep" flag indicating whether data is kept or not is stored in an area CT.

Fig. 5 shows the memory architecture of the EEPROM 7. As shown in Fig. 5, a large number of TEL data memories D₀, D₁,... are arranged in the EEPROM 7. In each of the TEL data memories D₀, D₁,..., alphabetic name data is stored in an area DX, telephone number data is stored in an area DY, order data indicating the order of read operations in a sequential search is stored in an area DZ, and a "keep" flag indicating whether data is kept or not is stored in an area DT.

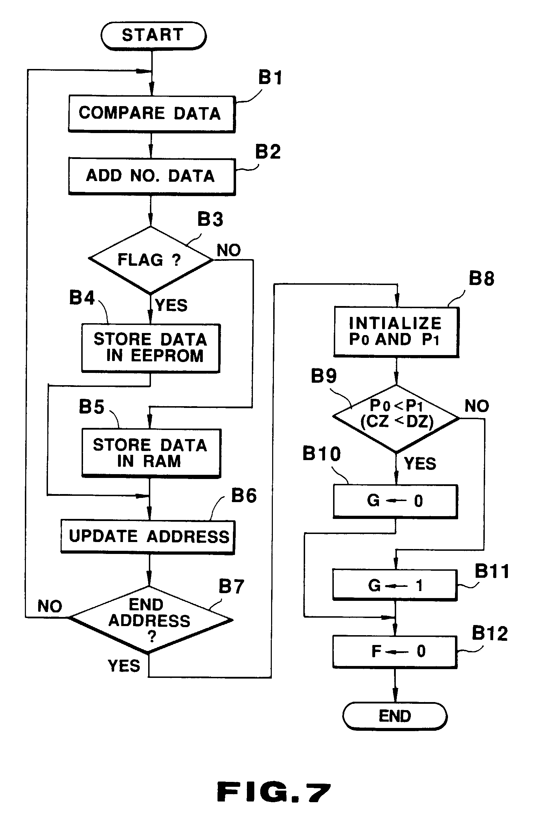

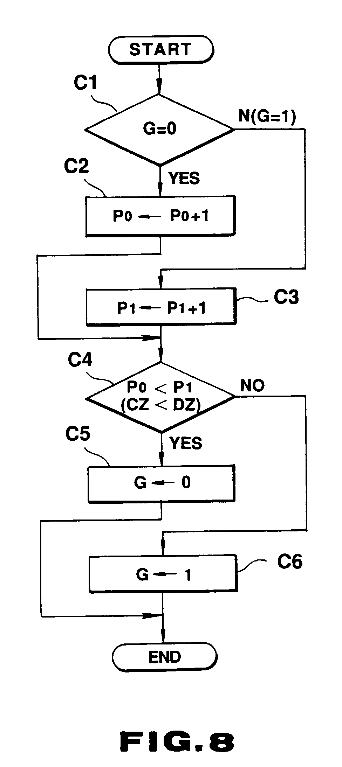

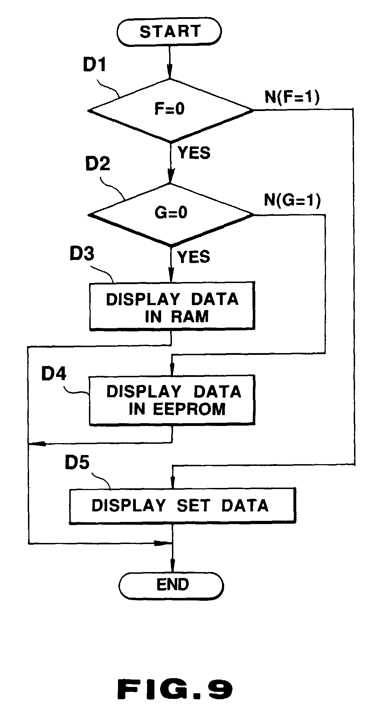

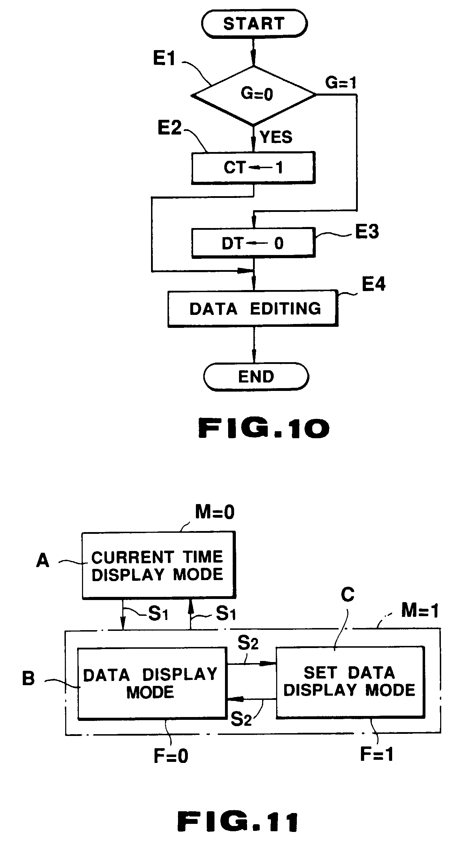

An operation of the apparatus of the above embodiment will be described next with reference to Figs. 6 to 14. Fig. 6 is a flow chart showing the overall operation. Fig. 7 is a flow chart showing a routine of data editing processing in Fig. 6. Fig. 8 is a flow chart showing a routine of data sequential search processing in Fig. 6. Fig. 9 is a flow chart showing a routine of data display processing in Fig. 6. Fig. 10 is a flow chart showing a routine of data transfer processing in Fig. 6.

The overall operation will be described first with reference to Fig. 6. The control section 4 is kept in a "HALT" state in step A1 until a timepiece signal is output from the frequency dividing/timing signal generating circuit 13.

When the timepiece signal is output, the presence of the timepiece signal is determined in step A1, and the flow advances to step A2. In step A2, timepiece processing is performed to update current time data stored in the timepiece register. In step A3, it is checked whether "M = 0", i.e., the content of the mode register M is "0". If YES in step A3, the flow advances to step A4 to perform current time display processing.

In the current time display processing, the current time data stored in the timepiece register of the RAM 6 is displayed on the LCD 2, as indicated by "A" in Fig. 11. After the processing in step A4 is completed, the flow returns to step A1.

In contrast to this, if "M = 1", NO is obtained in step A3, and the flow advances to step A5 to perform data display processing. In step A5, data display processing is performed to display name data and telephone number data on the LCD 2. The flow then returns to step A1. The data display processing will be described in detail later with reference to Fig. 9.

When one of the S₁ key to the S₆ key is operated, the presence of a key input is determined in step A1, and the flow advances to step A6. In step A6, it is checked whether the operated key is the S₁ key. If the S₁ key is operated, YES is obtained in step A6, and the flow advances to step A7. In step A7, the content of the mode register M is inverted to switch the modes. For example, if the S₁ key is operated when "M = 0", "M = 1" is set, and the data display mode is set, as indicated by "B" in Fig. 11. If the S₁ key is input when "M = 1", "M = 0" is set, and the current time display mode is set, as indicated by "A" in Fig. 11. After the processing in step A7 is completed, the flow advances to step A3.

If NO in step A6, the flow advances to step A8. In step A8, it is checked whether the operated key is the S₂ key. If the S₂ key is operated, YES is obtained in step A8, and the flow advance to step A9. In step A9, it is checked whether "M = 1", i.e., the content of the mode register M is "1". If YES in step A9, the flow advances to step A10. If NO in step A9, the flow advances to step A20.

If "M = 1" in step A9, YES is obtained, and the flow advances to step A10. In step A10, it is checked whether "F = 0", i.e., the content of the flag register F is "0". If YES in step A10, the flow advances to step All. If NO in step A10, the flow advances to step A12. If "F = 0", YES is obtained in step A10, the flow advances to step All. In step All, "1" is written in the flag register F, and "M = 1, F = 1" is set. As a result, the set data display mode is set, as indicated by "C" in Fig. 11. After the processing in step All is completed, the flow advances to step A3.

If NO (F = 1) in step A10, the flow advances to step A12. In step A12, data editing processing is executed, and the flow advances to step A3. The data editing processing will be described in detail later with reference to Fig. 7.

If NO in step A8, the flow advances to step A13. In step A13, it is checked whether the operated key is the S₃ key. If the S₃ key is operated, YES is obtained in step A13, and the flow advances to step A14. In step A14, it is checked whether "M = 1" is set. If YES in step A14, the flow advances to step A15. If NO in step A14, the flow advances to step A20. IF "M = 1" is set, i.e., YES is obtained in step A14, and the flow advances to step A15. In step A15, it is checked whether "F = 0" is set. If YES in step A15, the flow advances to step A16. If NO in step A15, the flow advances to step A20. If "F = 0" is set, YES is obtained in step A15, and the flow advances to step A16 to execute data sequential search processing. The data sequential search processing will be described in detail later with reference to Fig. 8. After the processing in step A16 is completed, the flow advances to step A3.

If NO in step A13, the flow advances to step A17. In step A17, it is checked whether the operated key is the S₄ key. If YES in step A17, the flow advances to step A18. If NO in step A17, the flow advances to step A20. If the S₄ key is operated, YES is obtained in step A17, and the flow advances to step A18. In step A18, it is checked whether "M = 1, F = 0" is set. If YES in step A18, the flow advances to step A19. If NO in step A18, the flow advances to step A20. If "M = 1, F = 0" is set, YES is determined in step A18, and the flow advances to step A19. In the data transfer processing in step A19, displayed data is transferred from the RAM 6 to the EEPROM 7 or from the EEPROM 7 to the RAM 6 and editing processing of the transferred data is performed. The data transfer processing will be described in detail later with reference to Fig. 10. The flow advances from step A19 to step A3.

In step A20, other key input processing is performed. Other key input processing is, for example, current time setting, digit position selection in the data set state in which "M = 1, F = 1" is set, and data correction processing by character selection. After the processing in step A20 is executed, the flow advances to step A3.

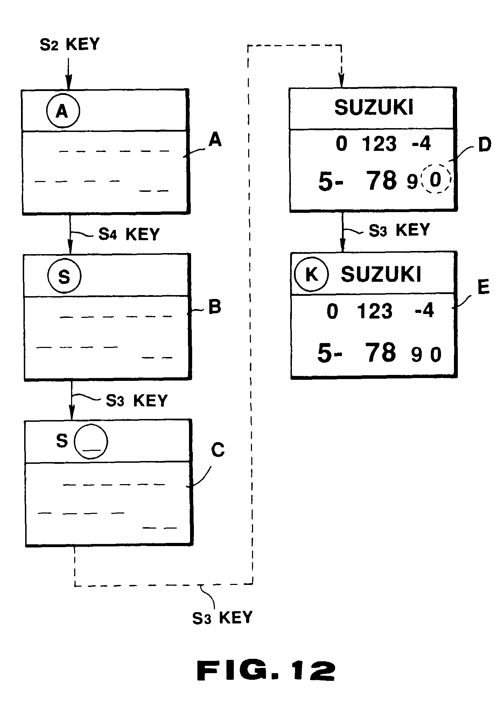

Setting of name/telephone-number data in other key processing in step A20 will be described next with reference to Fig. 12. The S₁ key is operated in advance to perform the processing in step A7 so as to set "M = 1". In addition, the S₂ key is operated to perform the processing in step All so as to set "F = 1".

With this operation, the flow advances to step A5 to perform set data display processing in the data display mode, thus flickering the character "A" on the dot matrix display portion 2a of the LCD 2, as shown in Fig. 12A.

In this case, if the S₄ key is sequentially operated, the characters "A", "B", "C",... are sequentially selected, and the character "S" is flickered, as shown in Fig. 12B. When the display character "S" is to be set, the S₃ key is operated to select the next digit position.

With this operation, the flashed display is shifted to the second digit position in the dot matrix display portion 2a, as shown in Fig. 2C. When the S₃ and S₄ keys are subsequently operated in the same manner as described above to set character data and numeric data, a name "SUZUKI" is displayed on the dot matrix display portion 2a, as shown in Fig. 12D, and a telephone number "0123-45-7890" is displayed on the numeric segment display portions 2b and 2c, while the numeral "0" at the lowest digit position is flickered.

If the S₃ key is operated in this state, "1" is written in the flag register G to set "G = 1", and the EEPROM 7 is selected. As a result, as shown in Fig. 12E, the "keep" mark display portion of the LCD 2 is flickered. The flickering "keep" mark "K" indicates that the displayed name/telephone-number data "SUZUKI 0123-45-7890" is stored/kept in the EEPROM 7.

If the S₄ key is operation in this state, the "keep" mark "K" disappears. This state indicates that the above-mentioned data is stored in the RAM 6.

If the S₂ key is operated in the state shown in Fig. 12E or in the state wherein the "keep" mark "K" disappears, the processing in step A12 is executed to store the name/telephone-number data in the EEPROM 7 or the RAM 6 and edit the data.

The data editing processing in step A12 will be described in detail below with reference to Fig. 7. If the S₂ key is operated in the state of "M = 1, F = 1", the data editing processing in step A12 is executed.

In step B1, newly set data is compared with each data stored in the RAM 6 and the EEPROM 7 to search for the start data of the name data arranged in the alphabetical order.

In step B2, the order data of the start data of the alphabetically arranged name data is set to be "1". In step B3, it is checked whether the start data has the "keep" flag ("1" data). That is, if the input data is the start data, it is checked whether "1" is set in the register G. If the start data is present in the data stored in the EEPROM 7 or the RAM 6, it is checked whether the content of the area CT or DT is "1". If YES in step B3, the flow advances to step B4. If NO in step B3, the flow advances to step B5.

In step B4, the data is stored in the EEPROM 7, and the flow advances to step B6.

If NO in step B3, the flow advances to step B5. In step B5, the data is stored in the RAM 6, and the flow advances to step B6.

In step B6, the address stored in the register P₀ or P₁ is updated. In step B7, it is checked whether the address designated by each of the registers P₀ and P₁ is the end address. If YES in step B7, the flow advances to step B8. If NO in step B7, the flow returns to step B1, and steps B1 to B7 are repeated. In this case, in step B2, order data are sequentially added, e.g., order data "2" in the second sequence, and order data "3" in the third sequence. When both the addresses designated by the registers P₀ and P₁ are end addresses, the flow advances to step B8. In step B8, the registers P₀ and P₁ are initialized to designate start addresses, respectively.

Subsequently, in step B9, the orders of name/telephone-number data designated by the initialized registers P₀ and P₁ are compared with each other. That is, the contents of the areas CZ and DZ of registers C₀ and D₀, which are respectively designated by the registers P₀ and P₁ are compared with each other, thus checking whether CZ < DZ. If YES in step B9, i.e., the content of the area CZ is smaller (higher in order) than that of the area DZ, the flow advances to step B10. If NO in step B9, i.e., it is determined that the content of the area CZ is larger (lower in order) than that of the area DZ, the flow advances to step B11.

In step B10, "0" is written in the flag register G, and "G = 0" is set. As a result, the name/telephone-number data stored in the RAM 6 is selected. After the processing in step B10 is executed, the flow advances to step B12.

In step B11, "1" is written in the flag register G, and "G = 1" is set. As a result, the name/telephone-number data stored in the EEPROM 7 is selected. The flow advances from step B11 to step B12.

In step B12, "0" is written in the flag register F to set "M = 1, F = 0", thus setting the data display mode indicated by "B" in Fig. 11. With the execution of step B12, the processing in Fig. 7 is completed.

Upon completion of the data editing processing in Fig. 7, "AKAO 33-4567 (CZ = 1)" and "ENDO 0521-21-1123 (CZ =3)" are stored, as name/telephone-number data, in the TEL data memories C₀ to Cₙ of the RAM 6, and "DOI 03-421-1151 (DZ = 2)" and "SUZUKI 0123-45-7890 (DZ = 4)" are stored, as name/telephone-number data, in the TEL data memories D₀, D₁,..., as shown in Fig. 4.

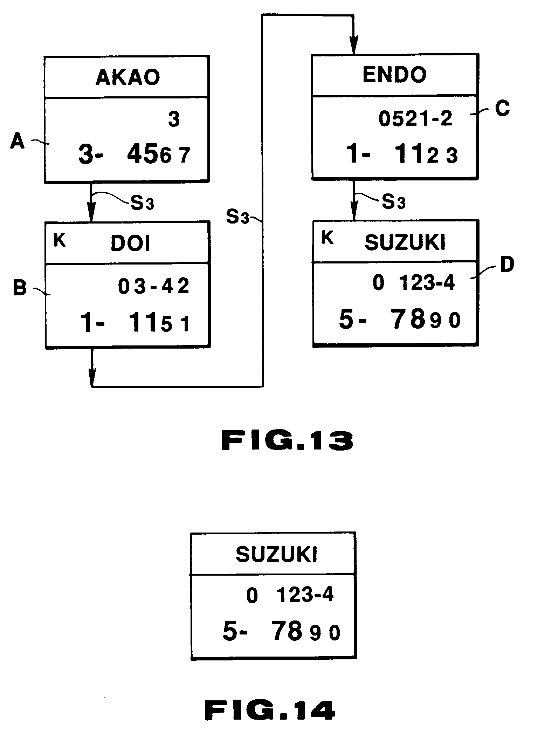

The data sequential search processing will be described below with reference to Fig. 8. In this case, since "M = 1, F = 0, G = 0" is set by the data editing processing described above, the name/telephone-number data "AKAO 33-4567" stored in the RAM 6 is displayed on the LCD 2, as shown in Fig. 13A. If the S3 key is operated in this state, the flow advances to step A16 through steps A13 to A15 in Fig. 6, and the data sequential search processing is executed.

In step C1, it is checked whether "G = 0" is set, i.e., the content of the flag register G is "0", and the RAM 6 is selected. If YES in step C1, i.e., the RAM 6 is selected, the flow advances to step C2. If NO (G = 1) in step C1, i.e., the EEPROM 7 is selected, the flow advances to step C3. In this case, since "G = 0" is set, and the name/telephone-number data of the RAM 6 is displayed, the flow advances to step C2.

In step C2, the content of the register P₀, which designates an address of the RAM 6, is incremented by one to address-designate the next name/telephone-number data "ENDO 0521-21-1123 (CZ = 3)" stored in the RAM 6. The flow then advances from step C2 to step C4.

In step C4, similar to step B9 described above, the orders of the name/telephone-number data designated by the registers P₀ and P₁ are compared with each other. More specifically, the content "3" of the area CZ and the content "2" of the area DZ respectively designated by the registers P₀ and P₁ are compared with each other to check whether CZ < DZ. If YES in step C4, i.e., the content of the area CZ is smaller than the content of the area DZ (higher in order), the flow advances to step C5. If NO in step C4, i.e., the content of the area CZ is larger than that content of the area DZ (lower in order), the flow advances to step C6. Since "CZ = 3, DZ = 2" in this case, NO is obtained in step C4, and the flow advanced to step C6. In step C6, "1" is written in the flag register G to set "G 1", and the EEPROM 7 is selected. With the execution of step C6, the processing in Fig. 8 is completed, and the flow advances to step A5 through step A3 to perform the data display processing.

If NO in step C1, the flow advances to step C3. In step C3, the register P₁ for address-designating the EEPROM 7 is incremented by one to address-designate the next data. The flow advances from step C3 to step C4 to check whether CZ < DZ.

If YES in step C4, the flow advances to step C5. In step C5, "0" is written in the flag register G to set "G = 0" and the RAM 6 is selected. With the execution of step C5, the processing in Fig. 8 is completed, and the flow advances to step A5 through step A3 to perform the data display processing.

The data display processing will be described in detail below with reference to Fig. 9. In step D1, it is checked whether "F = 0" is set, i.e., the content of the flag register F is "0". If YES in step D1, the flow advances to D2. If NO in step D1, the flow advances to step D5. In this case, since "F = 0" is set, YES is obtained in step D1, and the flow advances to step D2.

In step D2, it is checked whether "G = 0" is set. If YES in step D2, the flow advances to step D3. If NO in step D2, the flow advances to step D4. In this case, since "G = 1" is set, NO is obtained in step D2, and the flow advances to step D4. In step D4, the name/telephone-number data stored in the EEPROM 7 is read out on the basis of the address designated by the register P₁. In this case, since the register P₁ designates the start address, the name/telephone-number data "DOI 03-421-1151" is displayed together with the "keep" mark "K" on the LCD 2, as shown in Fig. 13B.

If the S₃ key is operated again in this state, the data sequential search processing is executed. Since "G = 0" is set, NO is obtained in step C1, and the flow advances to step C3. In step C3, the register P₁ is incremented by one to address-designate the next name/telephone-number data "SUZUKI 0123-45-7890 (DZ = 4)" stored in the EEPROM 7. The flow advances from step C3 to step C4. In step C4, it is checked whether CZ < DZ. Since "CZ = 3 and DZ = 4", YES is obtained in step C4, and the flow advances to step C5. In step C5, "0" is written in the flag register G to end the processing in Fig. 8, and the data display processing in Fig. 9 is executed.

Referring to Fig. 9 again, since "F = 0" is determined in step D1, the flow advances to step D2 to check whether "G = 0" is set. Since "G = 0" is set, YES is obtained in step D2, and the flow advances to step D3 to read out name/telephone-number data from the RAM 6 in accordance with the address designated by the register P₀. In this case, since the register P₀ address-designates the name/telephone-number data "ENDO 0521-21-1123 (CZ = 3)", the name/telephone-number data "ENDO 0521-21-1123" is displayed on the LCD 2, as shown in Fig. 13C.

If the S₃ key is operated in this state, the data sequential search processing is executed. Since "G = 0" is set, YES is obtained in step C1, and the flow advances to step C2 to increment the register P₀ by one, thus address-designating the next name/telephone-number data (CZ ≥ 5) stored in the RAM 6. The flow advances from step C2 to step C4. In step C4, it is checked whether CZ < DZ. Since CZ ≥ 5, and DZ = 4, NO is obtained in step C4, and the flow advances to step C6. In step C6, "1" is written in the flag register G to end the processing in Fig. 8, and the data display processing in Fig. 9 is executed.

Referring to Fig. 9 again, since "F = 0" is set in step D1, the flow advances to step D2 to check whether "G = 0" is set. In this case, since "G = 1" is set, NO is obtained in step D2, and the flow advances to step D4 to read out name/telephone-number data from the EEPROM 7 in accordance with the address designated by the register P₁. Since the register P₁ designates the name/telephone-number data "SUZUKI 0123-45-7890", the name/telephone-number data "SUZUKI 0123-45-7890" is displayed on the LCD 2 together with the "keep" mark "K", as shown in Fig. 13D.

In this manner, every time the S₃ key is operated, a sequential search for name/telephone-number data is performed in the alphabetical order. When the display data is to be transferred to the RAM 6 or the EEPROM 7, the S₄ key is operated. With this operation, the data transfer processing in step A19 is executed through steps A17 and A18.

The data transfer processing will be described in detail below with reference to Fig. 10. In step E1, it is checked whether "G = 0" is set with respect to displayed data. If YES in step E1, the flow advances to step E2. If NO (G = 1) in step E1, the flow advances to step E3. If "G = 0" is set, i.e., the display data is data in the RAM 6, step E2 is executed. If "G = 1" is set, i.e., the display data is data in the EEPROM 7, step E3 is executed. In step E3, "0" is written in the area DT of each of the TEL data memories D₀, D₁,... respectively address-designated by the register P₁, and the flow advances to step E4 to perform the data editing processing.

In step E4, similar to step A12, the name/telephone-number data is ranked and stored in the RAM 6 or the EEPROM 7 depending on whether the "keep" flag "1" is written in the area CT or DT. In this case, if the S₄ key is operated while the name/telephone-number data "SUZUKI 0123-45-7890" in the EEPROM 7 is displayed, since "0" is written in the area DT, this name/telephone-number data is stored in the RAM 6. After step E4 is executed, the processing in Fig. 10 is completed, and the flow advances to the data display processing sequence.

In the data display processing, as shown in Fig. 14, the displayed "keep" mark "K" disappears, and only the name/telephone-number data "SUZUKI 0123-45-7890" is displayed on the LCD 2.

If "G = 0", i.e., YES in step E1, the flow advances to step E2 to write the "keep" flag "1" in the area CT of each of the TEL data memories C₀ to Cₙ address-designated by the register P₀, and the flow advances to step E4 to perform data editing processing. Since the name/telephone-number data is ranked, and the "keep" flag "1" is written in the area CT, the name/telephone-number data is stored in the EEPROM 7.

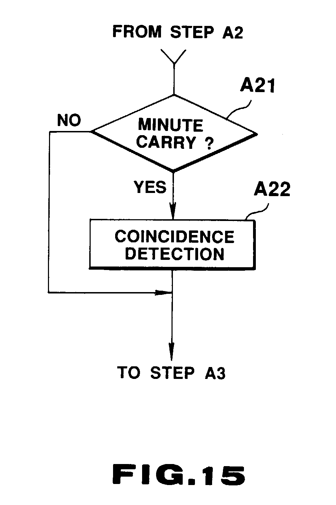

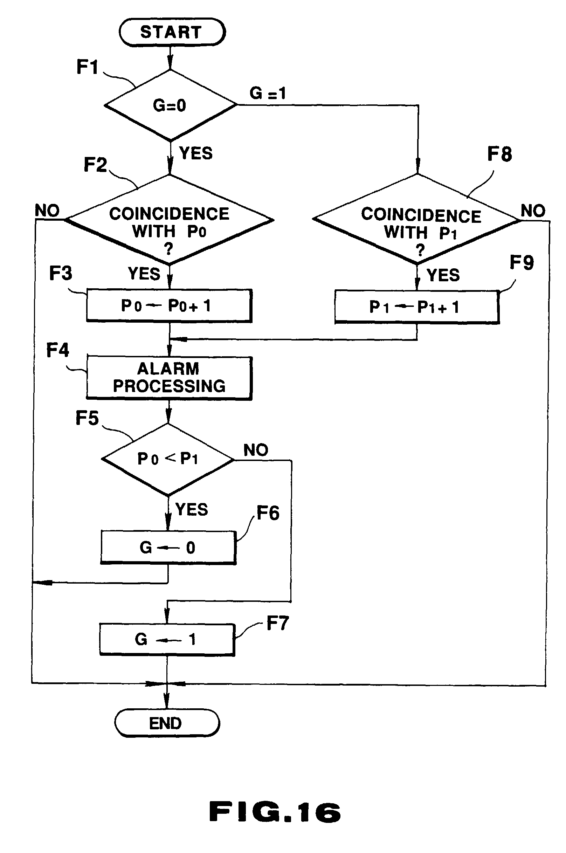

The second embodiment of the present invention will be described below with reference to Figs. 15 and 16. The second embodiment is designed to store schedule data in a RAM 6 and an EEPROM 7 in addition to name/telephone-number data. Each schedule data consists of schedule type data (e.g., "MEETING") and schedule time data (e.g., December 15, 10 : 30 am).

Schedule data stored in the RAM 6 and the EEPROM 7 are sequentially edited in the data editing processing in Fig. 7 in the order of schedule time closer to the current time.

Fig. 15 shows steps to be added between steps A2 and A3 in Fig. 6. More specifically, in the second embodiment, after the timepiece processing in step A2 is executed, the flow advances to step A21. In step A21, it is checked whether a minute carry is present, i.e., the minute data of the current time is updated. In step A22, coincidence detection processing is executed to detect whether schedule time coincides with the current time. This coincidence detection processing will be described in detail below with reference to Fig. 16.

In step F1, it is checked whether "G = 0" is set. If YES in step F1, the flow advances to step F2. If NO (G = 1) in step F1, the flow advances to step F8.

In step F2, it is checked whether the schedule time data in the RAM 6 designated by the register P₀ coincides with the current time. If YES in step F2, the flow advances to step F3. If NO in step F2, the processing in Fig. 16 is ended.

If YES in step F2, the flow advances to step F3 to increment the content of the register P₀ by one. In alarm processing in step F4, an alarm sound is generated to inform the arrival of the schedule time.

In step F5, the schedule time data respectively designated by the registers P₀ and P₁ are compared with each other to check whether the schedule time data designated by the register P₀ is closer in time to the current time than the schedule time data designated by the register P₁. If YES in F5, the flow advances to step F6. If NO in step F5, the flow advances to step F7.

If YES in step F5, the flow advances to step F6 to write "0" in the flag register G, and the processing in Fig. 16 is ended. If NO in step F5, the flow advances to step F7 to write "1" in the flag register G, and the processing in Fig. 16 is ended.

If NO in step F1, the flow advances to step F8 to check whether the schedule time data in the EEPROM 7 designated by the register P₁ coincides with the current time data. If YES in step F8, the flow advances to step F9. If NO in step, the processing in Fig. 16 is ended.

If YES in step F8, the flow advances to step F9 to increment the content of the register P₁ by one. As a result, the next schedule data is designated, and the flow advances to step F4. Subsequently, the processing in steps F4 to F7 is executed in the same manner as described above.

Figs. 17 to 21 show the third embodiment of the present invention. This embodiment exemplifies a case wherein the data write count limit of an EEPROM is exceeded. Fig. 17 shows a RAM used in place of the RAM 6 in Fig. 4, to which a register S is added. Fig. 18 shows an EEPROM, in which registers N0, N1, N2,... for storing a data write count are respectively arranged in registers D0, D1, D2,....

Fig. 19 is a flow chart showing the process of writing data in the EEPROM. In step H1, input data is written in a memory area designated by a pointer P₁ of a RAM 6. In step H2, the data in the memory area is read out. In step H3, it is checked whether the written data coincides with the read data.

When the two data coincide with each other, it means that the write operation is properly performed. In this case, in step H4, the value of a register N for storing a data write count with respect to the memory area is incremented. In step H5, an R mark display element 20 is displayed to end the data write operation.

If the written data and the read data do not coincide with each other, the flow advances to step H6 to increment the value of a register S for storing a data write repetition count. Furthermore, in step H7, it is checked whether the value of the register S has reached "20".

If the data write repetition count is less than 20, the flow returns to step H1 to write data in the designated memory area again.

If the data cannot be written after data write operations with respect to the same memory area are repeated 20 or more times, it is determined that the data write count limit of the memory area is exceeded, and no more data can be written there. In step H8, a search for an empty area is performed. In step H9, it is checked whether any empty area is present.

If YES in step H9, the flow returns to step H1 to write the data in the empty area.

If NO in step H9, the flow advances to step H10 to display that no data can be written.

"A" in Fig. 20 shows a display state of data. Referring to Fig. 20, when data is written in the memory area designated by the pointer P₁, the R mark display element 20 is turned on in step H5 to inform a user that the data write operation is completed.

If the data cannot be written in the designated memory area, and there are no other memory areas in which the data can be written, "Err" is displayed in step H10, as shown in Fig. 21.

Note that data write count data in each of the registers N0, N1, N2,... for storing a data write count with respect to the EEPROM may be displayed upon switch operation. For example, when an SX key (not shown) is operated in the state indicated by "A" of Fig. 20, a data write count of 230 with respect to the displayed area may be displayed, as indicated by "B" in Fig. 20.

In the above-described embodiments, name/telephone-number data and schedule data are input by operating the switches as input means. However, a terminal for communicating with an external unit may be arranged to receive data through this terminal in accordance with a predetermined format, e.g., the standards RS-232c or the like. Alternatively, in a paper or the like, an antenna and a radio circuit may be arranged as input means to receive data through radio signals.

## Claims

1. A wrist watch comprising:
data input means (3) for inputting data;
memory means (6) capable of storing the data input by said data input means;
display means (2,4,11) for displaying the data stored in said memory means (6,7);
characterized by
said memory means consisting of a volatile (6) and a nonvolatile memory means (7) capable of storing the data input by said input means;
selection switch means (G, S3) for selecting one of said volatile memory means (6) and said nonvolatile memory means (7) in which the data input by said data input means is stored,
storage control means (4) for causing the memory means (7) selected by the selection switch means (G, S3) to store the data input by said data input means (3)
indication displaying means (2e), when data stored in one of said volatile and nonvolatile memory means (6,7) is displayed, for displaying an indication denoting whether the displayed data is stored in said volatile memory means (6) or nonvolatile memory means (7).

2. A wrist watch according to claim 1, characterized in that said volatile memory means includes a RAM (6), and said nonvolatile memory means includes an EEPROM (7).

3. A wrist watch according to claims 1 or 2,
characterized in that said display means (2, 4, 11) comprises first display means for displaying the data stored in said volatile memory means, and second display means for displaying the data stored in said nonvolatile memory means.

4. A wrist watch according to any of claims 1 to 3, characterized by further comprising a battery power supply (9), and a power supply circuit (8) for supplying different driving voltages to said volatile memory means (6) and said nonvolatile memory means (7) in accordance with an output voltage from said battery power supply (9).

5. A wrist watch according to any of claims 1 to 4, characterized by further comprising count means (N) for counting the number of times that the data is stored in said nonvolatile memory means (7), and storage count display means (2, 4, 11) for displaying the number of storage operations counted by said count means (N).

6. A wrist watch according to any of claims 1 to 5, characterized by further comprising a timepiece circuit (4, 12, 13) for obtaining time information by counting reference signals, and time display means (4, 11, 12) for displaying the time information obtained by said timepiece circuit.

7. A wrist watch according to any of claims 1 to 6, characterized by further comprising adding means (4, CZ, DZ) for adding order data to each stored data in accordance with a predetermined order; and
characterized in that
said display means (2, 4, 11) sequentially displays the data stored in said volatile memory means (6) and said nonvolatile memory means (7) in accordance with the order data added by said adding means (4, CZ, DZ).

## Revendications

1. Montre-bracelet, comprenant :
un dispositif (3) de saisie de données,
un dispositif (6) à mémoire destiné à conserver les données saisies par le dispositif de saisie de données, et
un dispositif (2, 4, 11) d'affichage des données conservées dans le dispositif de mémoire (6, 7),
caractérisée en ce que
le dispositif à mémoire est constitué d'un dispositif à mémoire non permanente (6) et d'un dispositif à mémoire permanente (7) capable de conserver les données saisies par le dispositif de saisie de données,
un dispositif commutateur de sélection (G, S3) est destiné à sélectionner l'un des dispositifs de mémoire non permanente (6) et permanente (7) pour la conservation des données saisies par le dispositif de saisie,
un dispositif (4) de commande de mémorisation est destiné à provoquer la mémorisation des données saisies par le dispositif (3) de saisie de données par le dispositif de mémoire (7) sélectionné par le dispositif de commutation de sélection (G, S3), et
un dispositif d'affichage d'indication (2e) est destiné, lorsque les données conservées dans le dispositif de mémoire non permanente et permanente (6, 7) sont affichées, à afficher une indication du fait que les données affichées sont conservées dans le dispositif de mémoire non permanente (6) ou le dispositif de mémoire permanente (7).

2. Montre-bracelet selon la revendication 1, caractérisée en ce que le dispositif de mémoire non permanente comporte une mémoire à accès directe RAM (6) et le dispositif de mémoire permanente comporte une mémoire EEPROM (7).

3. Montre-bracelet selon la revendication 1 ou 2, caractérisée en ce que le dispositif d'affichage (2, 4, 11) comporte un premier dispositif d'affichage des données conservées dans le dispositif de mémoire non permanente et un second dispositif d'affichage des données conservées dans le dispositif de mémoire permanente.

4. Montre-bracelet selon l'une des revendications 1 à 3, caractérisée en ce qu'elle comporte en outre une alimentation (9) à pile et un circuit d'alimentation (8) destiné à transmettre différentes tensions de pilotage au dispositif de mémoire non permanente (6) et au dispositif de mémoire permanente (7) en fonction de la tension de sortie de l'alimentation à pile (9).

5. Montre-bracelet selon l'une des revendications 1 à 4, caractérisée en ce qu'elle comporte en outre un dispositif (N) de comptage du nombre de mémorisations de données dans le dispositif de mémoire permanente (7), et un dispositif (2, 4, 11) d'affichage du nombre d'opérations de mémorisation comptées par le dispositif (N) de comptage.

6. Montre-bracelet selon l'une des revendications 1 à 5, caractérisée en ce qu'elle comporte en outre un circuit de garde temps (4, 12, 13) destiné à l'obtention d'informations d'heures par comptage de signaux de référence, et un dispositif (4, 11, 12) d'affichage d'heure destiné à afficher l'information d'heure obtenue par le circuit de garde temps.

7. Montre-bracelet selon l'une des revendications 1 à 6, caractérisée en ce qu'elle comporte en outre un dispositif d'addition (4, CZ, DZ) destiné à ajouter des données d'ordre à chacune des données mémorisées en fonction d'un ordre prédéterminé, et caractérisée en ce que
le dispositif d'affichage (2, 4, 11) affiche successivement les données conservées dans le dispositif de mémoire non permanente (6) et le dispositif de mémoire permanente (7) en fonction des données d'ordre ajoutées par le dispositif d'addition (4, CZ, DZ).

## Patentansprüche

1. Armbanduhr, umfassend:
eine Dateneingabeeinrichtung (3) zum Eingeben von Daten;
eine Speichereinrichtung (6), die imstande ist, die durch die Dateneingabeeinrichtung eingegebenen Daten zu speichern;
eine Anzeigeeinrichtung (2, 4, 11) zum Anzeigen der in der Speichereinrichtung (6, 7) gespeicherten Daten;
gekennzeichnet durch
die Speichereinrichtung, die aus einer flüchtigen (6) und einer nichtflüchtigen Speichereinrichtung (7) besteht, die zum Speichern der durch die Dateneingabeeinrichtung eingegebenen Daten imstande sind;
eine Auswahlschaltereinrichtung (G, S3) zum Auswählen der flüchtigen Speichereinrichtung (6) oder der nichtflüchtigen Speichereinrichtung (7), in der die durch die Dateneingabeeinrichtung eingegebenen Daten gespeichert werden;
eine Speichersteuereinrichtung (4), die die durch die Auswahlschaltereinrichtung (G, S3) ausgewählte Speichereinrichtung (7) veranlaßt, die durch die Dateneingabeeinrichtung (3) eingegebenen Daten zu speichern, und
eine Hinweisanzeigeeinrichtung (2e), die, wenn in einer der flüchtigen und nichtflüchtigen Speichereinrichtungen (6, 7) gespeicherte Daten angezeigt werden, einen Hinweis anzeigt, der angibt, ob die angezeigten Daten in der flüchtigen Speichereinrichtung (6) oder der nichtflüchtigen Speichereinrichtung (7) gespeichert werden.

2. Armbanduhr nach Anspruch 1, dadurch gekennzeichnet, daß die flüchtige Speichereinrichtung ein RAM (6) umfaßt und die nichtflüchtige Speichereinrichtung ein EEPROM (7) umfaßt.

3. Armbanduhr nach Anspruch 1 oder 2, dadurch gekennzeichnet, daß die Anzeigeeinrichtung (2, 4, 11) eine erste Anzeigeeinrichtung zum Anzeigen der in der flüchtigen Speichereinrichtung gespeicherten Daten und eine zweite Anzeigeeinrichtung zum Anzeigen der in der nichtflüchtigen Speichereinrichtung gespeicherten Daten umfaßt.

4. Armbanduhr nach einem der Ansprüche 1 bis 3, gekennzeichnet durch weiter umfassend eine Batteriestromversorgung (9) und eine Stromversorgungsschaltung (8) zum Liefern verschiedener Treibspannungen an die flüchtige Speichereinrichtung (6) und die nichtflüchtige Speichereinrichtung (7) nach Maßgabe einer Ausgangsspannung der Batteriestromversorgung (9).

5. Armbanduhr nach einem der Ansprüche 1 bis 4, gekennzeichnet durch weiter umfassend eine Zähleinrichtung (N) zum Zählen der Anzahl von Malen, die Daten in die nichtflüchtige Speichereinrichtung (7) geschrieben werden, und eine Speicherungszählungs-Anzeigeeinrichtung (2, 4, 11) zum Anzeigen der durch die Zähleinrichtung (N) gezählten Anzahl von Speicherungsoperationen.

6. Armbanduhr nach einem der Ansprüche 1 bis 5, gekennzeichnet durch weiter umfassend eine Uhrenschaltung (4, 12, 13) zum Erlangen von Zeitinformation durch Zählen von Bezugssignalen und eine Zeitanzeigeeinrichtung (4, 11, 12) zum Anzeigen der durch die Uhrenschaltung erlangten Zeitinformation.

7. Armbanduhr nach einem der Ansprüche 1 bis 6, gekennzeichnet durch weiter umfassend eine Hinzufügungseinrichtung (4, CZ, DZ), um allen gespeicherten Daten Reihenfolgedaten nach Maßgabe einer vorbestimmten Reihenfolge hinzuzufügen, und dadurch gekennzeichnet, daß
die Anzeigeeinrichtung (2, 4, 11) die in der flüchtigen Speichereinrichtung (6) und der nichtflüchtigen Speichereinrichtung (7) gespeicherten Daten nach Maßgabe der durch die Hinzufügungseinrichtung (4, CZ, DZ) hinzugefügten Reihenfolgedaten nacheinander anzeigt.
